# EUROPÄISCHE PATENTANMELDUNG

(11) **EP 1 128 424 A2**
(43) Veröffentlichungstag der Anmeldung: **29.08.2001**
(21) Anmeldenummer: 01101731.6
(22) Anmeldetag: 25.01.2001
(51) Int. Cl.: H01L 21/66

(54) **Teststruktur bei integriertem Halbleiter**

(30) Priorität: 25.02.2000 DE 10010285
(71) Anmelder: Infineon Technologies AG, 81669 München (DE)
(72) Erfinder: Richter, Frank, 01108 Dresden (DE)
(74) Vertreter: Fischer, Volker, Dipl.-Ing.

(57) **Zusammenfassung**

Mit zunehmender Integrationsdichte integrierter Schaltkreise kann die Packungsdichte in zwischen den integrierten Schaltkreisen liegenden Testbereichen (Kerf-Strukturen) nicht wesentlich erhöht werden, da der größte Teil der zur Verfügung stehenden Fläche von Kontaktflächen eingenommen wird. Die Erfindung ist daher gerichtet auf einen Teststrukturbereich (1) auf einem Wafer mit Kontaktflächen (2) zum Anlegen von Spannungen und Testbauelementen (3) zwischen den Kontaktflächen (2), der dadurch gekennzeichnet ist, dass zumindest zwei Testbauelemente (3) zwischen jeweils zwei benachbarten Kontaktflächen (2) angeordnet sind, welche mit den benachbarten Kontaktflächen (2) verbunden sind, so dass eine Spannung über die Kontaktflächen (2) an die Testbauelemente (3) anlegbar ist.

## Beschreibung

Die vorliegende Erfindung betrifft einen Teststrukturbereich auf einem Wafer, insbesondere ein Teststrukturbereich, der zwischen zwei integrierten Schaltkreisen auf einem Wafer angeordnet sein kann.

Integrierte Schaltkreise werden auf monokristallinen Siliziumscheiben, sogenannten Wafern, hergestellt. Da die auf einem Wafer zur Verfügung stehende Flasche erheblich größer ist als die Fläche eines integrierten Schaltkreises, werden eine Vielzahl von integrierten Schaltkreisen, zumeist identische, auf jedem produziertem Wafer untergebracht. Während der Herstellung von integrierten Schaltkreisen werden immer wieder photolithograhische Prozesse verwendet, bei denen der Wafer durch eine Maske belichtet wird. Durch diesen Belichtungsvorgang werden beispielsweise herauszuätzende Strukturen des integrierten Schaltkreises in einem Photolack festgelegt. Aus Rationalisierungsgründen werden zumeist mehrere Masken für mehrere nebeneinander liegende integrierte Schaltkreise auf einem lithographischen Film angeordnet und gemeinsam belichtet. Die auf diese Weise gemeinsam belichteten integrierten Schaltkreise werden als Retikel bezeichnet. Zwischen den einzelnen integrierten Schaltkreisen befindet sich ein Zwischenraum, in dem die fertiggestellten integrierten Schaltkreise durch Sägen oder Ätzen voneinander vereinzelt werden können. Der Zwischenraum wird dabei chemisch oder mechanisch entfernt.

Allerdings wird der Zwischenraum vor dem Vereinzeln für Testzwecke verwendet, indem auf den zusammenhängenden Masken zur Herstellung eines Retikels zwischen den eigentlichen Bereichen der integrierten Schaltkreise Teststrukturen vorgesehen sind, die mit aufbelichtet werden und den Zwischenraum zwischen den einzelnen integrierten Schaltkreisen ausfüllen.

Diese Teststrukturen bestehen üblicherweise aus Kontaktflächen (sogenannten Pads) und zwischen den Kontaktflächen angeordneten Testbauteilen, zumeist Transistoren, wobei jeweils ein Testbauteil zwischen zwei Kontaktflächen liegt.

Nach Fertigstellung der integrierten Schaltkreise eines Wafers können diese Testbereiche kontaktiert und die Funktionsfähigkeit der auf ihnen angeordneten Testbauteile, beispielsweise der Transistoren überprüft werden. Die Funktionsfähigkeit der Transistoren liefert ein recht zuverlässiges Bild von der Güte des Herstellungsprozesses der integrierten Schaltkreise auf dem jeweiligen Wafer. Man kann davon ausgehen, dass Probleme, welche sich in den Testbereichen zeigen, auch in den integrierten Schaltkreisen vorliegen, so dass diese frühzeitig aussortiert werden können, bevor ihre Disfunktionalität in einem wesentlich komplizierteren Testverfahren, das diesem allgemeinen Test nachgeschaltet ist, festgestellt wird.

Mit zunehmender Integrationsdichte der integrierten Schaltkreise, insbesondere bei Speicherbausteinen, wie DRAM, SDRAM, RAMBUS oder EDRAM tritt allerdings das Problem auf, dass auf einer bestimmten Fläche des Wafers eine immer größere Zahl von Funktionsbauelementen angeordnet wird. Demgegenüber kann die Packungsdichte in den zwischen den integrierten Schaltkreisen liegenden Testbereichen nicht wesentliche erhöht werden, da der größte Teil der zur Verfügung stehenden Fläche von den praktisch nicht verkleinerbaren Kontaktflächen eingenommen wird. Es sinkt daher mit zunehmender Integrationsdichte das Verhältnis zwischen Zahl der Testbauteile und Zahl der Funktionsbauteile. Diese Verringerung der Anzahl von testbaren Einzelstrukturen und der damit verbundene Informationsverlust, insbesondere in der Entwicklung und beim Produktionsstart eines neuen Produkts, war ein im Stand der Technik begangener, hochgradig unbefriedigender Weg.

In der EP 0 133 955 A1 ist eine Teststruktur zur Kennzeichnung von Halbleiterchips gezeigt, bei der zwischen zwei Anschlußflächen Bauelemente in Parallelschaltung vorgesehen sind. Nach einem Test werden zur Kennzeichnung des Halbleiterchips eines oder mehrere der Bauelemente aufgetrennt. Es können Anschlußflächen verwendet werden, die im Normalbetrieb nicht zugänglich sind. Ein Schwellschalter, z.B. ein Dickoxidtransistor, verhindert eine Beeinflussung der Teststruktur an die ansonsten angeschlossenen Schaltungsteile des Halbleiterchips.

In der US 5 942 766 ist eine andere Teststruktur zur Messung von RF-Parametern von auf einem Wafer angeordneten integrierten Schaltungen gezeigt. Die Teststrukturen sind zwischen den integrierten Schaltungen angeordnet. Sie umfassen je eine Anschlußfläche, die für das Testelement als Eingang oder Ausgang oder Masse dient.

Der vorliegenden Erfindung liegt daher die Aufgabe zugrunde, die Zahl der testbaren Einzelstrukturen, respektive Testbauelemente, bezogen auf die Chipfläche der integrierten Schaltkreise, zu erhöhen.

Diese Aufgabe wird erfindungsgemäß gelöst durch die Bereitstellung eines Teststrukturbereichs auf einem Wafer gemäß dem unabhängigen Patentanspruch 1.

Weitere vorteilhafte Ausgestaltungen, Aspekte und Details der vorliegenden Erfindung ergeben sich aus den abhängigen Patentansprüchen, der Beschreibung und den beigefügten Zeichnungen.

Es ist ein Teststrukturbereich auf einem Wafer mit Kontaktflächen zum Anlegen von Spannungen und Testbauelementen zwischen den Kontaktflächen vorgesehen, wobei bei diesem Teststrukturbereich zumindest zwei Testbauelemente zwischen jeweils zwei benachbarten Kontaktflächen angeordnet sind, welche mit den benachbarten Kontaktflächen verbunden sind, so dass eine Spannung über die Kontaktflächen an die Testbauelemente anlegbar ist.

Die Gate-Anschlüsse der Transistoren sind an weitere Kontaktflächen angeschlossen, um einen Schaltstrom zuzuführen. Dadurch können die Gate-Anschlüsse der Transistoren unabhängig voneinander angesteuert und die Transistoren unabhängig voneinander getestet werden.

Dadurch wird die Zahl der testbaren Testbauelemente zwischen den Kontaktflächen vergrößert. Bislang war man davon ausgegangen, dass es nur sinnvoll sei, jeweils ein Testbauelement zwischen zwei Kontaktflächen zu legen.

Die Testbauelemente sind Transistoren. Diese können beispielsweise an ihren Source-Bereichen mit einer benachbarten Kontaktfläche und an Drain-Bereichen mit der anderen benachbarten Kontaktfläche verbunden sein. Die Gate-Bereiche können beispielsweise auch über einen gemeinsamen Pol laufen, der beim Testen des Teststrukturbereichs ein- und ausgeschaltet werden kann, über spezielle dafür vorgesehene Kontaktflächen.

Die Gate-Anschlüsse der Transistoren sind vorzugsweise aber getrennt voneinander ansteuerbar, um wechselweise zwischen den Transistoren durch einen jeweiligen Stromimpuls umzuschalten. Die Gate-Anschlüsse werden über entsprechende Leitungen an je eine weitere Kontaktfläche angeschlossen.

Wie bereits dargelegt, ist die Erfindung vorzugsweise auf Teststrukturbereiche gerichtet, welche zwischen zwei integrierten Schaltkreisen angeordnet sind. Die Erfindung eignet sich jedoch auch für die Bereitstellung von Teststrukturbereichen in anderen Regionen integrierter Schaltkreise, insbesondere auch in solchen Regionen, die nicht nach dem Test entfernt werden. Gerade bei hoch komplexen Chips, beispielsweise Prozessoren, welche eine vergleichsweise große Chipfläche belegen, kann es sinnvoll sein, auch im Inneren jeder Chipfläche Teststrukturbereiche der erfindungsgemäßen Art vorzusehen.

Der erfindungsgemäße Teststrukturbereich kann vorzugsweise eine Breite von 50 bis 200 Um aufweisen. Die Breite ist maßgeblich von der Größe der Kontaktflächen, die in einer Reihe angeordnet sein können, bestimmt und definiert den für die Anordnung von Testbauelementen zur Verfügung stehenden Platz in der Breite.

Im folgenden soll die Erfindung an Hand eines konkreten Ausführungsbeispiels erläutert werden, wobei auf die beigefügten Zeichnungen Bezug genommen werden soll, in denen folgendes dargestellt ist.
- Figur 1: zeigt in Übersicht einen im Stand der Technik bekannten gesamten Teststrukturbereich; und
- Figur 2: zeigt zwischen Kontaktflächen eines erfindungsgemäßen Teststrukturbereichs angeordnete Testtransistoren.

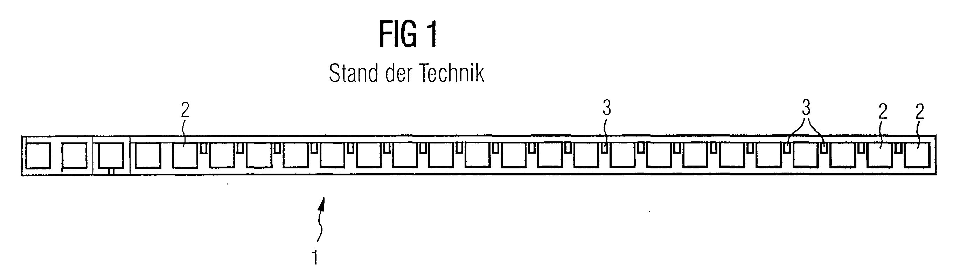

Figur 1 zeigt einen Teststrukturbereich 1, über dessen Länge verteilt Kontaktflächen 2 angeordnet sind. Der Teststrukturbereich 1 liegt zwischen zwei integrierten Schaltungen auf einem Halbleiterwafer im Sägerahmen, dem sogenannten Kerf. Längs des Sägeerahmens werden die Haltleiterschaltungen nach dem Test zersägt und dadurch vereinzelt. Die Kontaktflächen sind voneinander beabstandet. Im Zwischenraum zwischen jeweils zwei benachbarten Kontaktflächen sind Testbauelemente 3, beispielsweise Transistoren angeordnet. Diese sind an ihren Source-/Drain-Bereichen mit jeweils zwei benachbarten Kontaktflächen verbunden. Zugleich ist auch jede Kontaktfläche mit zwei benachbarten Transistoren verbunden, so dass jede Kontaktfläche wahlweise als Spannungsgeber für ein Source-oder einen Drain-Bereich eingesetzt werden kann. Bei der Testung des Teststrukturbereichs sind die Spannungen entsprechend auf die Testnadeln zu legen.

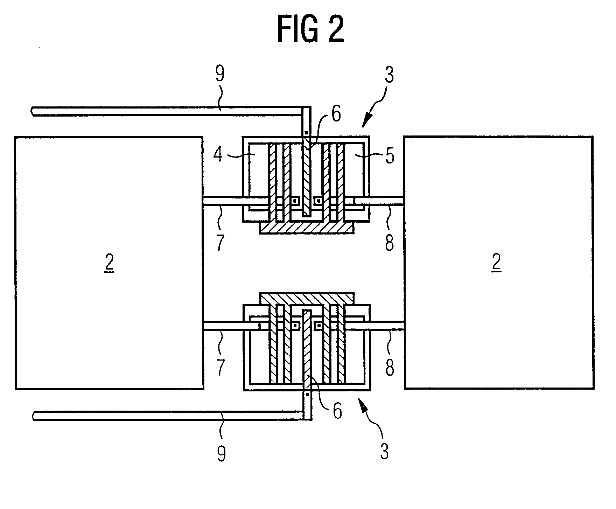

Figur 2 zeigt die erfindungsgemäße Anordnung von zwei Testtransistoren zwischen Kontaktflächen 2. Es ist jedoch auch vorstellbar, die Zahl der Transistoren weiter zu erhöhen. Jeder Transistor weist einen Source-Bereich 4 und einen Drain-Bereich 5 sowie einen Gate-Bereich 6 auf. Der Source-Bereich 4 ist über eine Leiterbahn 7 mit der linken der beiden Kontaktflächen 2 verbunden, während der Drain-Bereich 5 über eine Leiterbahn 8 mit der rechten der beiden Kontaktflächen 2 verbunden ist. Diese Schaltungsanordnung ist bei beiden Transistoren 3 gleich. Vorstellbar ist auch, die Transistoren so auszuführen, dass sie gemeinsame Source-/Drain- oder Gate-Bereiche aufweisen. Dem Fachmann ist die Realisierung solcher gemeinsamen Bereiche bekannt. Die Leiterbahnen 9 sind am Gate-Bereich 6 angeordnet und führen zu nicht dargestellten Kontaktflächen, über die ein Schaltstrom den Transistoren zugeführt werden kann.

In einer Ausführungsform ist vorgesehen, dass die beiden Transistoren 3, 3 der Teststrukturbereiche wechselweise schaltbar sind. Beispielsweise ist der obere der Transistoren über einen an seiner Gateleitung 9 dem Gate-Anschluß 6 zugeführten Schaltstrom leitend gesteuert, so dass er über die rechts und links angeordneten Kontaktflächen 2, 2 testbar ist. In diesem Fall ist dann der untere Transistor abgeschaltet. In der anderen Einstellung kann der untere der Transistoren über einen entsprechenden an seinem Gate-Anschluß über die Leitung 9 zugeführten Schaltstrom eingeschaltet werden, während der obere der Transistoren abgeschaltet ist. Dann sind die Charakteristiken des unteren der Transistoren testbar. Dadurch können beide Transsitoren zu Testzwecken wechselweise aktiviert werden. Dies schließt ein, dass beide Transistoren auch gleichzeitig eingeschaltet und paralel getestet werden.

Zur wechselweisen, voneinander unabhängigen Steuerung des oberen und des unteren der Transistoren 3, 3 in Figur 2 sind getrennte zusätzliche Kontaktflächen oder Anschlußpads vergleichbar den eingezeichneten Anschlußpads 2 vorgesehen. Diese Pads sind (nicht dargestellt) in Fortsetzung in Figur 2 links neben der bereits eingezeichneten linken Kontaktfläche 2 angeordnet, wobei eines dieser zusätzlichen Pads mit der oberen Leiterbahn 9 verbunden ist und die andere der zusätzlichen Kontaktflächen mit der unteren Leiterbahn 9 verbunden ist. Somit können den beiden Transistoren unabhängig voneinander entsprechende Steuersignale zugeführt werden, um die Transistoren unabhängig voneinander vollständig ein- oder auszuschalten oder entsprechend dem geswünschten Test anzusteuern. Dies schließt ein, dass die beiden Transistoren auch paralell mit dem gleichen Signal angesteuert werden.

Die erfindungsgemäße Lösung der gestellten Aufgabe führt zu einer optimalen Ausnutzung der vorhandenen Zwischenbereiche (der sogenannten Kerf-Bereiche). Zugleich kommt es zu einer massiven Reduktion der notwendigen Makrobereiche. Eine wie im Stand der Technik bekannte Verringerung der Pad-Geometrien zum Zweck der Kompensation fehlender Testflächen ist nicht mehr notwendig. Dadurch, dass keine neue Ausrüstung beschafft werden muß, kommt es zu einer bedeutenden Einsparung von Investitionsmitteln. Insgesamt kann eine optimale Device-Entwicklung für zukünftige Shrink-Generationen und neue SDRAM und EDRAM-Produkte durch Verhindern von aus Platzmangel bedingten Kürzungen an wichtigen Transistorstrukturen gesichert werden.

## Patentansprüche

1. Teststrukturbereich (1) auf einem Wafer mit Kontaktflächen (2) zum Anlegen von Spannungen an Testbauelemente (3), die zwischen die Kontaktflächen (2) geschaltet sind, bei dem die Testbauelemente (3) Transistoren sind und zumindest zwei Transistoren (3) zwischen jeweils zwei benachbarten Kontaktflächen (2) angeordnet sind und mit den benachbarten Kontaktflächen (2) verbunden sind, so dass eine Spannung über die Kontaktflächen (2) an die Transistoren (3) anlegbar ist, und bei dem die Gate-Anschlüsse (6) der Transistoren (3) an weitere Kontaktflächen angeschlossen sind, um einen Schaltstrom zuzuführen.

2. Teststrukturbereich (1) nach Anspruch 1,
**dadurch gekennzeichnet**, dass
die Transistoren an Source-Bereichen (4) mit einer benachbarten Kontaktfläche (2) und an Drain-Bereichen (5) mit der anderen benachbarten Kontaktfläche (2) verbunden sind.

3. Teststrukturbereich (1) nach einem der Ansprüche 1 bis 2,
**dadurch gekennzeichnet**, dass
der Teststrukturbereich (1) zwischen zwei integrierten Schaltkreisen angeordnet ist.

4. Teststrukturbereich (1) nach einem der Ansprüche 1 bis 3,
**dadurch gekennzeichnet**, dass
der Teststrukturbereich (1) eine Breite von 50 bis 200 Mikrometern aufweist.

5. Teststrukturbereich (1) nach einem der Ansprüche 1 bis 4,
**dadurch gekennzeichnet**, dass
die Gate-Anschlüsse (6) der mindestens zwei Transistoren (3) an je eine weitere Kontaktfläche angeschlossen sind, um wechselweise zwischen den Transistoren umzuschalten.
